# FASCICULE DE BREVET EUROPEEN

(11) **EP 3 637 071 B1**
(45) Date de publication et mention de la délivrance du brevet: **28.07.2021**
(21) Numéro de dépôt: 19202535.1
(22) Date de dépôt: 10.10.2019
(51) Int. Cl.: G01J 5/04, B81C 1/00

(54) **PROCEDE DE FABRICATION D'UN DISPOSITIF DE DETECTION D'UN RAYONNEMENT ELECTROMAGNETIQUE A STRUCTURE D'ENCAPSULATION AMELIOREE**
HERSTELLUNGSVERFAHREN EINES DETEKTORS VON ELEKTROMAGNETISCHER STRAHLUNG MIT VERBESSERTER EINKAPSELUNGSSTRUKTUR
METHOD FOR MANUFACTURING AN ELECTROMAGNETIC-RADIATION DETECTION DEVICE WITH IMPROVED ENCAPSULATION STRUCTURE

(30) Priorité: 12.10.2018 FR 1859483
(43) Date de publication de la demande: 15.04.2020
(73) Titulaire: Commissariat à l'Énergie Atomique et aux Énergies Alternatives, 75015 Paris (FR)
(72) Inventeur: YON, Jean-Jacques, 38054 GRENOBLE Cedex 09 (FR); DUMONT, Geoffroy, 38054 GRENOBLE Cedex 09 (FR)
(74) Mandataire: INNOV-GROUP

(56) Documents cités:
- EP-A1- 1 694 597
- EP-A2- 3 067 675
- JP-A- 2017 202 953
- US-A1- 2014 147 955
- GEOFFROY DUMONT ET AL: "Innovative on-chip packaging applied to uncooled IRFPA", PROCEEDINGS OF SPIE, vol. 6940, 3 avril 2008 (2008-04-03), page 69401Y, XP055286288, US DOI: 10.1117/12.780433 ISBN: 978-1-5106-1533-5

## Description

### DOMAINE TECHNIQUE

Le domaine de l'invention est celui des procédés de fabrication de dispositifs de détection d'un rayonnement électromagnétique, en particulier infrarouge ou térahertz, comportant une structure d'encapsulation qui forme une cavité dans laquelle est logé au moins un détecteur thermique. L'invention s'applique notamment au domaine de l'imagerie infrarouge ou térahertz, de la thermographie, voire de la détection de gaz.

### ÉTAT DE LA TECHNIQUE ANTÉRIEURE

Les dispositifs de détection de rayonnement électromagnétique, par exemple infrarouge ou térahertz, peuvent comprendre une matrice de détecteurs thermiques comportant chacun une membrane apte à absorber le rayonnement électromagnétique à détecter et contenant un transducteur thermométrique tel qu'un matériau thermistance. Pour assurer l'isolation thermique des transducteurs thermométriques vis-à-vis du substrat de lecture, les membranes absorbantes sont habituellement suspendues au-dessus du substrat par des piliers d'ancrage, et sont isolées thermiquement de celui-ci par des bras d'isolation thermique. Ces piliers d'ancrage et bras d'isolation thermique présentent également une fonction électrique en connectant les membranes absorbantes au circuit de lecture généralement disposé dans le substrat.

Pour assurer un fonctionnement optimal des détecteurs thermiques, un faible niveau de pression peut être requis. Pour cela, les détecteurs thermiques sont généralement confinés, ou encapsulés, seuls ou à plusieurs, dans au moins une cavité hermétique sous vide ou à pression réduite. La cavité hermétique est définie par une structure d'encapsulation, également appelée capsule, comme l'illustre le document de Dumont et al, Current progress on pixel level packaging for uncooled IRFPA, Proc. SPIE 8353, Infrared Technology and Applications XXXVIII, 83531I, 2012, dans une configuration dans laquelle la structure d'encapsulation définit une pluralité de cavités hermétiques encapsulant chacune un unique détecteur thermique (configuration dite *Pixel Level Packaging,* en anglais).

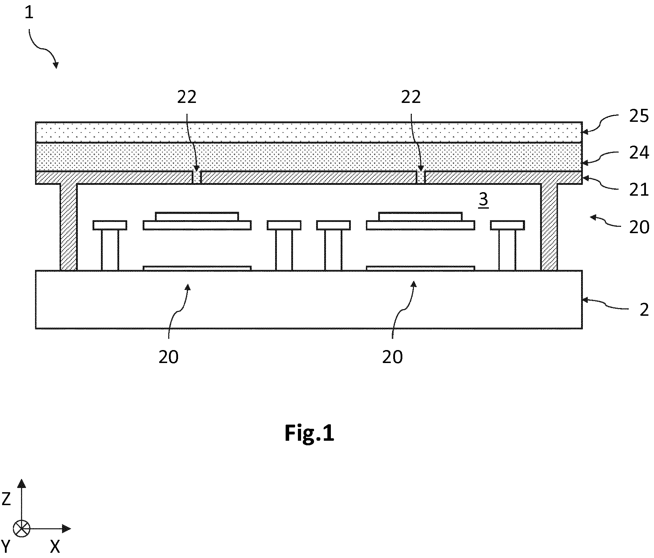

Le brevet US9933309 décrit un autre exemple de dispositif de détection 1 dans lequel la structure d'encapsulation 20 définit une cavité hermétique 3 encapsulant une matrice de détecteurs thermiques 10. Comme l'illustre la figure 1, la structure d'encapsulation 20 comporte alors une couche mince d'encapsulation 21 qui définit, avec le substrat 2, la cavité hermétique 3. La couche mince d'encapsulation 21 comporte une pluralité d'évents de libération permettant l'évacuation, hors de la cavité 3, des couches sacrificielles utilisées lors du procédé de fabrication. Une couche mince de scellement 24 recouvre au moins partiellement la couche d'encapsulation et assure l'herméticité de la cavité en obturant les évents de libération 22. Les couches minces d'encapsulation et de scellement 21, 24 sont réalisées en des matériaux transparents au rayonnement électromagnétique à détecter. Une couche mince antireflet 25 peut recouvrir la couche mince de scellement 24.

Les couches minces d'encapsulation et de scellement peuvent être réalisées en des matériaux distincts, par exemple en silicium amorphe pour la couche d'encapsulation et en germanium pour la couche de scellement, qui présentent alors des coefficients de dilatation thermique (CTE, pour *Coefficient of Thermal Expansion,* en anglais) différents. Or, le procédé de fabrication d'un tel dispositif de détection peut comporter une ou plusieurs étapes au cours desquelles le dispositif en cours de réalisation est exposé à des températures élevées. Il peut ainsi s'agir, à titre purement illustratif, d'une activation à 300°C environ d'un matériau getter situé dans la cavité hermétique 3, ce matériau getter étant destiné à réagir avec du gaz résiduel éventuellement présent dans la cavité pour maintenir celle-ci à un niveau de vide suffisant. Il s'avère que la différence de coefficients CTE entre les matériaux des couches d'encapsulation et de scellement peut alors générer des contraintes mécaniques dans la structure d'encapsulation pouvant entraîner une fragilisation de sa tenue mécanique.

EP3067675 A2, EP1694597A1, US2014/147955A1, JP2017202953A présentent d'autres exemples de dispositifs de détection comportant des structures d'encapsulation.

### EXPOSÉ DE L'INVENTION

L'invention a pour objectif de remédier au moins en partie aux inconvénients de l'art antérieur, et plus particulièrement de proposer un procédé de fabrication d'un tel dispositif de détection permettant de renforcer la tenue mécanique de la structure d'encapsulation.

Pour cela, l'objet de l'invention est un procédé de fabrication d'un dispositif de détection d'un rayonnement électromagnétique comportant au moins un détecteur thermique reposant sur un substrat et une structure d'encapsulation définissant avec le substrat une cavité dans laquelle est situé le détecteur thermique. Le procédé comporte les étapes suivantes :
∘ réalisation du détecteur thermique à partir d'au moins une première couche sacrificielle déposée sur un substrat ;
∘ réalisation d'une couche mince d'encapsulation de la structure d'encapsulation s'étendant au-dessus du détecteur thermique à partir d'au moins une deuxième couche sacrificielle reposant sur la première couche sacrificielle, la couche mince d'encapsulation étant réalisée en un matériau d'encapsulation ;
∘ réalisation par dépôt physique en phase vapeur d'une couche mince dite de scellement recouvrant la couche mince d'encapsulation, la couche mince de scellement étant réalisée en un matériau de scellement présentant un coefficient de dilatation thermique différent de celui du matériau d'encapsulation.

Selon l'invention, le procédé comporte en outre l'étape suivante :
∘ préalablement à l'étape de réalisation de la couche mince de scellement, réalisation d'au moins un relief sur la couche mince d'encapsulation, présentant une épaisseur moyenne adaptée de sorte que, lors du dépôt de la couche mince de scellement, celle-ci est formée d'au moins une portion de couche reposant sur la couche mince d'encapsulation, et d'au moins un plot distinct de la portion de couche et reposant sur le relief, formant ainsi une rupture locale de continuité de la couche mince de scellement au niveau du relief.

Certains aspects préférés, mais non limitatifs de ce procédé de fabrication sont les suivants.

Le relief peut former un réseau à deux dimensions de portions longitudinales entourant au moins partiellement, en projection orthogonale par rapport au substrat, le détecteur thermique.

Le réseau de portions longitudinales du relief peut entourer, en projection orthogonale par rapport au substrat, le détecteur thermique de manière continue.

Le détecteur thermique peut comporter une membrane absorbante suspendue au-dessus du substrat et contenant un transducteur thermométrique, le relief étant disposé à distance, en projection orthogonale par rapport au substrat, de la membrane absorbante.

La couche mince de scellement peut présenter une épaisseur moyenne e_{cs}, le relief présentant une épaisseur moyenne eᵣ supérieure ou égale à un cinquième de l'épaisseur moyenne e_{cs}.

L'étape de réalisation du relief peut comporter un dépôt d'une première couche en un matériau distinct de celui de la couche mince d'encapsulation, puis une structuration locale par gravure sélective de la première couche vis-à-vis de la couche mince d'encapsulation de manière à former le relief.

Le dispositif de détection peut comporter une matrice de détecteurs thermiques disposée dans ladite cavité, le relief formant un réseau à deux dimensions de portions longitudinales entourant au moins partiellement, en projection orthogonale par rapport au substrat, chacun des détecteurs thermiques.

La couche mince d'encapsulation peut être réalisée à base de silicium et la couche mince de scellement être réalisée à base de germanium.

La couche mince de scellement est de préférence déposée par évaporation.

Le procédé de fabrication peut comporter une étape de réalisation d'une couche mince antireflet par dépôt physique en phase vapeur sur la couche mince de scellement, la couche mince antireflet présentant alors une rupture locale de continuité.

Le procédé de fabrication peut comporter :
- entre l'étape de réalisation du relief et l'étape de réalisation de la couche mince de scellement, une étape de formation d'au moins un orifice traversant dit évent de libération au travers de la couche mince d'encapsulation, la couche mince de scellement étant ensuite réalisée de manière à obturer l'évent de libération,
- une étape de suppression des couches sacrificielles au travers de l'évent de libération.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1, déjà décrite, est une vue en coupe, schématique et partielle, d'un dispositif de détection selon un exemple de l'art antérieur ;
les figures 2A à 2J illustrent, en vue en coupe schématique et partielle, différentes étapes d'un procédé de fabrication du dispositif de détection selon un mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, l'expression « comportant un » doit être comprise, sauf indication contraire, comme « comportant au moins un » et non pas comme « comportant un unique ».

L'invention porte sur un procédé de fabrication d'un dispositif de détection d'un rayonnement électromagnétique. Le dispositif de détection comporte au moins un détecteur thermique encapsulé, seul ou à plusieurs, dans une cavité avantageusement hermétique définie par une structure d'encapsulation. Le détecteur thermique peut être adapté à détecter un rayonnement infrarouge ou térahertz. Il peut en particulier détecter un rayonnement infrarouge compris dans la bande de longueurs d'onde infrarouges longues (bande LWIR) allant de 7µm à 14µm environ.

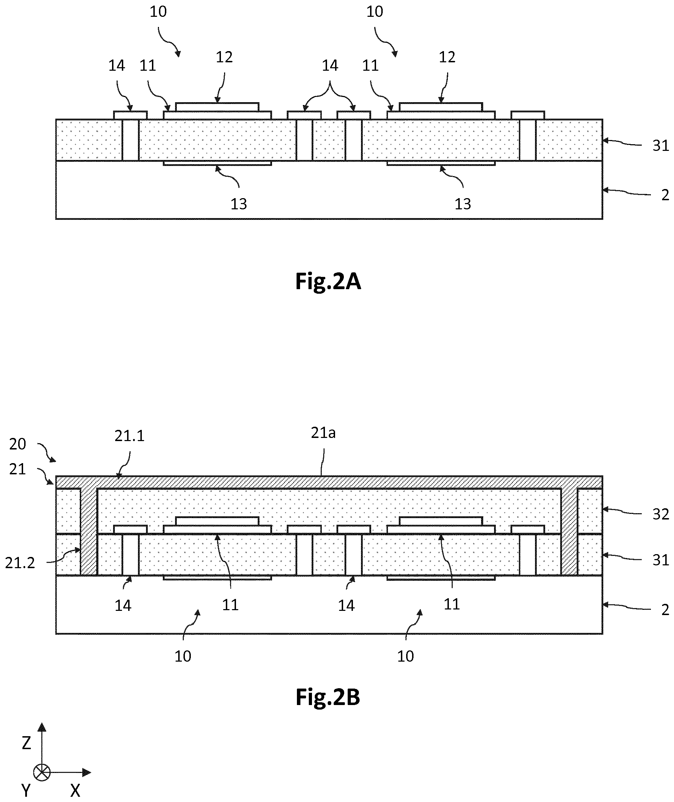

Les figures 2A à 2J illustrent différentes étapes d'un procédé de fabrication d'un dispositif de détection 1 selon un mode de réalisation.

Dans ce mode de réalisation, chaque détecteur thermique 10 comporte une membrane absorbante 11 contenant un transducteur thermométrique 12 adapté à détecter un rayonnement infrarouge dans la bande LWIR. Le transducteur thermométrique 12 est un élément présentant une propriété électrique variant avec son échauffement, et est ici un matériau thermistance formé par exemple d'oxyde de vanadium ou de titane, ou de silicium amorphe. En variante, il peut s'agir d'une capacité formée par un matériau pyroélectrique ou ferroélectrique, d'une diode (jonction pn ou pin), voire d'un transistor à effet de champ et à structure métal - oxyde - semiconducteur (MOSFET).

Par ailleurs, le détecteur thermique 10 présente ici une configuration dans laquelle le transducteur thermométrique 12 est disposé dans une membrane suspendue au-dessus d'un substrat de lecture 2 et adaptée à absorber le rayonnement électromagnétique à détecter. La membrane absorbante 11 est située dans le même plan que les bras d'isolation thermique. D'autres configurations sont possibles, par exemple une configuration dans laquelle la membrane absorbante 11 est située au-dessus des bras d'isolation thermique, comme décrit notamment dans la demande WO2018/055276, voire une configuration dans laquelle l'absorbeur est distinct et disposé au-dessus de la membrane contenant le transducteur thermométrique 12, comme décrit par exemple dans US2009140147.

Le dispositif de détection 1 comporte ici une matrice de détecteurs thermiques 10 formant des pixels sensibles. La structure d'encapsulation 20 définit une cavité 3 de préférence hermétique encapsulant la matrice de détecteurs thermiques 10. En variante, le dispositif de détection 1 peut comporter une pluralité de cavités encapsulant chacune un unique détecteur thermique 10, comme décrit notamment dans l'article de Dumont et al. 2012 mentionné précédemment.

On définit ici et pour la suite de la description un repère direct tridimensionnel (X,Y,Z), où le plan XY est sensiblement parallèle au plan d'un substrat de lecture 2 du dispositif de détection 1, l'axe Z étant orienté suivant une direction sensiblement orthogonale au plan XY du substrat de lecture 2. Par ailleurs, les termes « inférieur » et « supérieur » s'entendent comme étant relatifs à un positionnement croissant lorsqu'on s'éloigne du substrat de lecture 2 suivant la direction +Z.

Dans cet exemple, les détecteurs thermiques 10 sont réalisés en utilisant des couches sacrificielles minérales 31, 32 destinées à être ultérieurement supprimées par gravure humide en milieu acide (HF vapeur). D'autres techniques peuvent être utilisées, comme l'utilisation de couches sacrificielles en polyimide ou équivalent supprimées ensuite par gravure sèche par exemple sous plasma O₂

En référence à la fig.2A, on réalise tout d'abord la matrice de détecteurs thermiques 10 au moyen d'au moins une première couche sacrificielle 31 déposée sur le substrat 2. Cette étape est identique ou similaire à celle décrite notamment dans le brevet US9933309.

Le dispositif de détection 1 comporte un substrat de lecture 2, réalisé dans cet exemple à base de silicium, contenant un circuit électronique (non représenté) permettant la commande et la lecture du détecteur thermique 10. Le circuit de lecture se présente ici sous la forme d'un circuit intégré CMOS situé dans un substrat support. Il comporte des portions de lignes conductrices, par exemple métalliques, séparées les unes des autres par un matériau diélectrique, par exemple un matériau minéral à base de silicium tel qu'un oxyde de silicium SiOₓ, un nitrure de silicium SiNₓ, ou leurs alliages. Il peut également comporter des éléments électroniques actifs ou passifs (non représentés), par exemple des diodes, transistors, condensateurs, résistances..., connectés par des interconnexions électriques au détecteur thermique 10 d'une part, et à un plot de connexion (non représenté) d'autre part, ce dernier étant destiné à connecter le système de détection à un dispositif électronique externe.

On réalise également le réflecteur 13 de chaque détecteur thermique 10. Le réflecteur 13 est ici formé par une portion d'une ligne conductrice du dernier niveau d'interconnexion, celle-ci étant réalisée en un matériau adapté à réfléchir le rayonnement électromagnétique à détecter. Il s'étend en regard de la membrane absorbante 11, et est destiné à former avec celle-ci une cavité interférentielle quart d'onde vis-à-vis du rayonnement électromagnétique à détecter.

Dans le cas où les couches diélectriques inter-métal sont réalisées en un matériau minéral, et où les couches sacrificielles 31, 32 utilisées pour réaliser les détecteurs thermiques 10 et la structure d'encapsulation 20 sont réalisées également en un matériau minéral, la face supérieure du substrat de lecture 2 est recouverte par une couche de protection (non représentée). Celle-ci correspond ici à une couche d'arrêt de gravure réalisée en un matériau sensiblement inerte à l'agent de gravure chimique utilisé ultérieurement pour supprimer les couches sacrificielles minérales, par exemple au milieu HF en phase vapeur. Cette couche de protection forme ainsi une couche hermétique et chimiquement inerte. Elle est électriquement isolante pour éviter tout court-circuit entre les portions de lignes conductrices. Elle permet ainsi d'éviter que les couches isolantes minérales sous-jacentes ne soient gravées lors de cette étape de suppression des couches sacrificielles. Elle peut être formée en un oxyde ou nitrure d'aluminium, en nitrure ou trifluorure d'aluminium, ou en silicium amorphe non intentionnellement dopé.

On dépose tout d'abord une première couche sacrificielle 31 sur le substrat de lecture 2, par exemple réalisée en un matériau minéral tel qu'un oxyde de silicium SiOₓ déposé par dépôt chimique en phase vapeur assisté par plasma (PECVD). Ce matériau minéral est apte à être supprimé par gravure chimique humide, en particulier par attaque chimique en milieu acide, l'agent de gravure étant de préférence de l'acide fluorhydrique (HF) en phase vapeur. Cette couche sacrificielle minérale 31 est déposée de manière à s'étendre continûment sur sensiblement toute la surface du substrat de lecture 2 et recouvrir ainsi la couche de protection. L'épaisseur de la couche sacrificielle 31 suivant l'axe Z peut être de l'ordre de quelques centaines de nanomètres à quelques microns.

On réalise ensuite les piliers d'ancrage 14 au travers de la couche sacrificielle 31, ainsi que les bras d'isolation thermique (non représentés) et la membrane absorbante 11 qui reposent sur la couche sacrificielle 31. La membrane absorbante 11 est destinée à être suspendue au-dessus du substrat de lecture 2 par les piliers d'ancrage 14, et est isolée thermiquement du substrat de lecture 2 par les bras d'isolation thermique. Les piliers d'ancrage 14 sont électriquement conducteurs, et traversent localement la couche de protection pour assurer un contact électrique avec le circuit de lecture. La membrane absorbante 11 est espacée du substrat de lecture 2, et en particulier de la couche réflectrice, d'une distance non nulle. Cette distance est de préférence ajustée de manière à former une cavité interférentielle quart d'onde optimisant l'absorption du rayonnement électromagnétique à détecter par la membrane 11. Elle est typiquement comprise entre 1µm et 5µm, de préférence 2µm, lorsque le détecteur thermique 10 est conçu pour la détection d'un rayonnement infrarouge dans la bande LWIR. La membrane absorbante 11 intègre un matériau thermistance, connecté au circuit de lecture par les bras d'isolation thermique et les piliers d'ancrage 14.

On réalise ensuite la structure d'encapsulation 20. D'une manière générale, la structure d'encapsulation 20, ou capsule, définit avec le substrat de lecture 2 une cavité 3 avantageusement hermétique à l'intérieur de laquelle se trouve ici la matrice de détecteur thermique 10. La structure d'encapsulation 20 comporte au moins une couche mince d'encapsulation 21 recouverte par au moins une couche mince de scellement 24. Les couches minces d'encapsulation et de scellement 21, 24 sont réalisées en des matériaux distincts, présentant des coefficients de dilatation thermique différents (CTE). A titre d'exemple, la couche mince d'encapsulation 21 peut être réalisée en silicium amorphe et la couche mince de scellement 24 peut être réalisée en germanium. Par couche mince, on entend une couche déposée par les techniques de dépôt de matériaux de la microélectronique, dont l'épaisseur est de préférence inférieure à 10µm.

En référence à la fig.2B, on dépose tout d'abord une deuxième couche sacrificielle 32, préférentiellement de même nature que la première couche sacrificielle 31. La couche sacrificielle 32 recouvre la couche sacrificielle 31 ainsi que la membrane absorbante 11 et les bras d'isolation thermique. Par des techniques classiques de photolithographie, on grave ensuite localement les couches sacrificielles 31, 32 jusqu'à la surface du substrat de lecture 2 (ou jusqu'à des portions d'accroche disposées sur le substrat). Les zones gravées peuvent prendre la forme de tranchées de périmètre continu et fermé entourant la matrice de détecteurs thermiques 10.

On procède ensuite au dépôt de la couche mince d'encapsulation 21, ici réalisée en silicium amorphe, qui recouvre à la fois la surface supérieure de la couche sacrificielle 32 et les flancs des tranchées, par exemple par un dépôt chimique en phase vapeur (CVD pour *Chemical Vapor Deposition,* en anglais). La couche mince d'encapsulation 21 comprend une paroi supérieure 21.1 qui s'étend au-dessus et à distance des détecteurs thermiques 10, et une paroi latérale 21.2 qui entoure dans le plan XY la matrice de détecteurs thermiques 10, de préférence de manière continue. La paroi supérieure 21.1 est sensiblement plane et s'étend au-dessus des détecteurs thermiques 10, à une distance non nulle des membranes suspendues, par exemple comprise entre 0,5µm et 5µm, de préférence comprise entre 0,5µm et 3,5µm, de préférence égale à 1,5µm. La paroi latérale 21.2 est ici périphérique de manière à entourer les détecteurs thermiques 10 dans le plan XY. Elle s'étend à partir de la paroi supérieure 21.1 et vient reposer localement sur le substrat de lecture 2. La couche mince d'encapsulation 21 s'étend donc dans cet exemple de manière continue au-dessus et autour de la matrice de détecteurs thermiques 10 de manière à définir la cavité 3 avec le substrat de lecture 2. La couche mince d'encapsulation 21 est réalisée en un matériau transparent au rayonnement électromagnétique à détecter, ici en silicium amorphe, et présente une épaisseur moyenne avantageusement égale à un multiple impair de λ/4n_{ce}, où λ est une longueur d'onde centrale de la bande de détection du rayonnement électromagnétique d'intérêt, par exemple 10µm dans le cas de la bande LWIR, et n_{ce} est l'indice optique du matériau de la couche mince d'encapsulation 21. Elle peut être comprise entre quelques centaines de nanomètres et quelques microns, par exemple égale à 800nm environ.

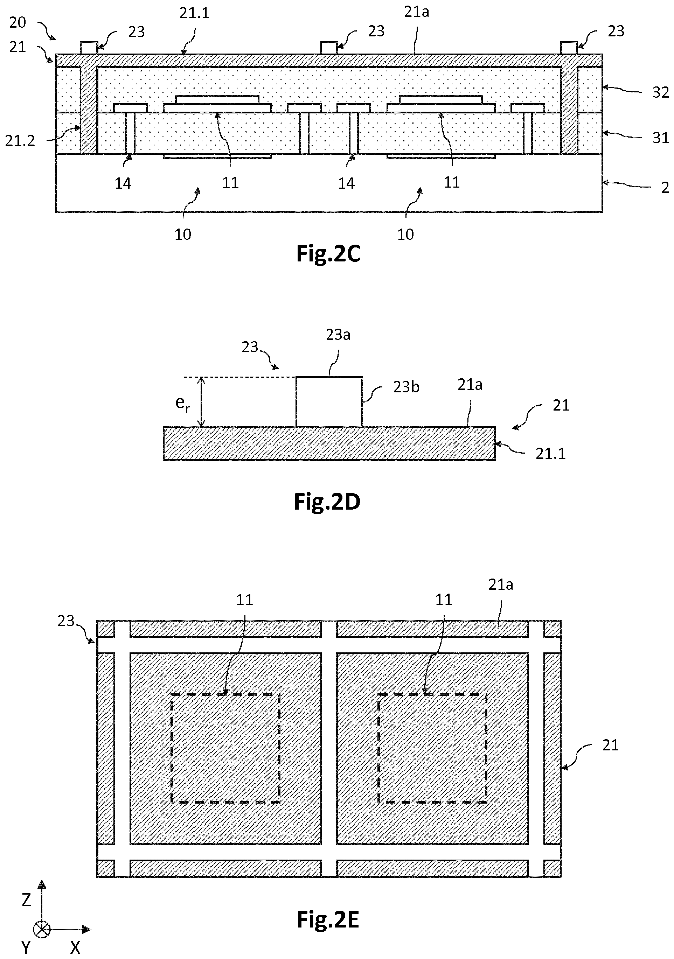

En référence à la fig.2C, 2D et 2E, on réalise ensuite le relief 23 sur la couche mince d'encapsulation 21, et plus précisément sur la paroi supérieure 21.1 de celle-ci. Par relief 23, on entend une portion d'un matériau s'étendant localement sur la couche mince d'encapsulation 21, formant une saillie vis-à-vis de la face supérieure 21a. Il présente avantageusement une face supérieure 23a qui s'étend de manière sensiblement parallèle à la face supérieure 21a de la couche mince d'encapsulation 21 sur laquelle il repose. La face supérieure 23a est bordée par des faces latérales 23b qui s'étendent de manière sensiblement orthogonale à la couche mince d'encapsulation 21. Aussi, le relief 23 peut alors présenter une section en coupe dans un plan transversal parallèle à l'axe Z d'une forme sensiblement rectangulaire ou carrée. On définit alors une épaisseur locale comme étant la dimension locale du relief 23 suivant l'axe Z. L'épaisseur moyenne eᵣ est définie comme étant la moyenne des épaisseurs locales. Cette épaisseur moyenne eᵣ est adaptée de manière à provoquer une rupture locale de continuité de la couche mince de scellement 24 réalisée ultérieurement par dépôt physique en phase vapeur.

Pour cela, on dépose de préférence une couche en un matériau distinct du matériau de la couche mince d'encapsulation 21 et présentant une sélectivité de gravure vis-à-vis de celui-ci. Ensuite, par photolithographie et gravure, on structure localement la couche déposée de manière à former le relief 23 sur la couche mince d'encapsulation 21. Le relief 23 peut être une ou plusieurs portions longitudinales qui s'étendent sur la couche mince d'encapsulation 21. Par portion longitudinale, on entend un volume de matériau qui présente une dimension longitudinale supérieure aux dimensions transversales de largeur et d'épaisseur. Les portions longitudinales sont de préférence jointes et continues les unes aux autres, mais peuvent en variante être disjointes les unes des autres. Le relief 23 peut également être formé d'une ou plusieurs portions distinctes présentant des dimensions du même ordre dans le plan XY.

De préférence, le relief 23 forme un réseau à deux dimensions, donc suivant deux axes transversaux parallèles au plan XY, de portions longitudinales entourant au moins partiellement, en projection orthogonale, chaque détecteur thermique 10. Par en projection orthogonale, ou en projection orthogonale par rapport au substrat, on entend en projection suivant l'axe Z dans un plan parallèle au plan du substrat 2. Par au moins partiellement, on entend que les portions longitudinales du relief 23 n'entourent qu'une partie du détecteur thermique 10 dans le plan XY. Les portions longitudinales peuvent ainsi être distinctes les unes des autres. De préférence, les portions longitudinales du relief 23 entourent, en projection orthogonale, chaque détecteur thermique 10 de manière continue. Ainsi, elles sont jointes entre elles et présentent ainsi une continuité de matière entre elles.

De préférence, le relief 23 est disposé à distance, en projection orthogonale, des détecteurs thermiques 10, et de préférence des membranes absorbantes 11, de manière à ne pas perturber la transmission du rayonnement électromagnétique à détecter. Autrement dit, le relief 23 est disposé à la perpendiculaire d'une zone ne comportant pas les membranes absorbantes 11. Il peut ainsi être disposé à la perpendiculaire des piliers d'ancrage 14, voire à la perpendiculaire d'une zone passant entre les piliers d'ancrage 14 de deux détecteurs thermiques 10 voisins.

Le relief 23 présente une épaisseur moyenne eᵣ adaptée de sorte que, lors de la réalisation ultérieure de la couche mince de scellement 24 par dépôt physique en phase vapeur sur la couche mince d'encapsulation 21 et sur le relief 23, la présence du relief 23 entraîne une rupture locale de continuité de la couche mince de scellement 24, i.e. une discontinuité de matière de la couche mince de scellement 24 dans le plan XY au niveau du relief 23. Le relief 23 présente une épaisseur moyenne eᵣ supérieure ou égale au cinquième environ de l'épaisseur moyenne e_{cs} de la couche mince de scellement 24, de préférence supérieure ou égale au quart, de préférence supérieure ou égale à la moitié environ de l'épaisseur moyenne e_{cs}. A titre d'exemple, dans le cas d'une couche mince de scellement 24 présentant une épaisseur moyenne de 1800nm, le relief 23 peut présenter une épaisseur supérieure ou égale à 400nm, par exemple égale à 800nm environ, voire à 1000nm.

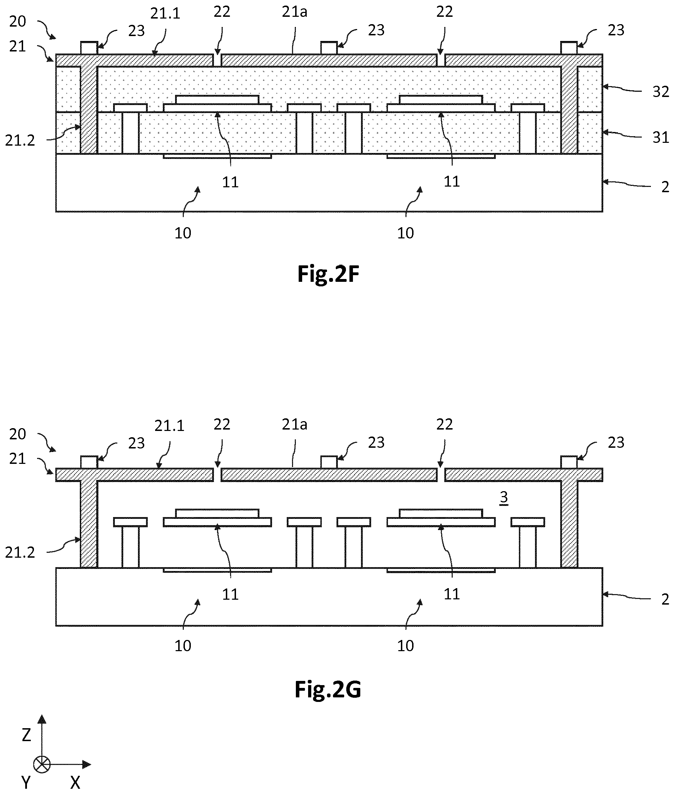

En référence à la fig.2F, on réalise ensuite une gravure localisée de la couche mince d'encapsulation 21 de manière à réaliser des orifices traversants formant les évents de libération 22. Chaque évent de libération 22 est ici avantageusement positionné en regard du centre d'une membrane absorbante 11. La membrane absorbante 11 peut alors être structurée de manière à présenter un orifice traversant (non représenté) situé en regard de l'évent de libération 22, comme décrit dans le document EP3067675.

En référence à la fig.2G, on réalise ensuite l'élimination des différentes couches sacrificielles 31, 32, ici par gravure humide en HF vapeur dans la mesure où il s'agit de couches sacrificielles minérales, à travers les différents évents de libération, de manière à mettre en suspension la membrane absorbante 11 de chaque détecteur thermique 10 et à former la cavité 3. On réalise, le cas échéant, la mise sous vide ou sous pression réduite du dispositif de détection 1.

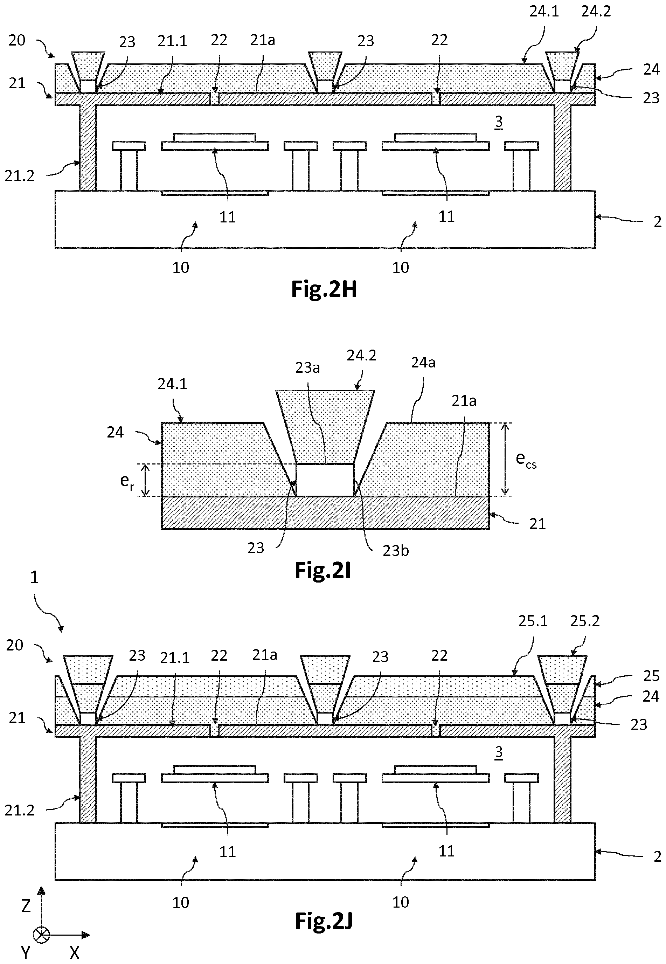

En référence à la fig.2H et 2I, on dépose ensuite la couche mince de scellement 24 de manière à recouvrir la couche mince d'encapsulation 21 et le relief 23, et de manière à obturer les évents de libération 22. La couche mince de scellement 24 est réalisée en un matériau transparent au rayonnement électromagnétique à détecter et à haut indice optique, par exemple en germanium ou en un alliage de silicium et germanium. Son épaisseur moyenne est ici ajustée de manière à être sensiblement égale à un multiple impair de λ/4ncs, où n_{cs} est l'indice optique du matériau de la couche mince de scellement 24. A titre d'exemple, la couche mince de scellement 24 peut être réalisée en germanium et présenter une épaisseur moyenne égale à 1800nm environ.

Le matériau de la couche mince de scellement 24 est distinct de celui de la couche mince d'encapsulation 21, et présente un coefficient de dilatation thermique différent. A titre d'exemple, il peut s'agir de germanium dont le coefficient CTE est égal à 5,9.10⁻⁶ K⁻¹ environ, qui est distinct, dans cet exemple, du silicium amorphe de la couche mince d'encapsulation 21 dont le coefficient CTE est égal à 2,6.10⁻⁶ K⁻¹ environ.

Le dépôt est réalisé par dépôt physique en phase vapeur (PVD, pour *Physical Vapor Deposition,* en anglais), par exemple par évaporation sous vide, par évaporation par faisceau d'électron (*Electron Beam Evaporation,* en anglais), par pulvérisation cathodique (*sputtering,* en anglais). Le dépôt PVD revient à former une couche mince d'un matériau sur la face supérieure d'une surface de réception. Ainsi, le matériau de la couche mince de scellement 24 se dépose sur la face supérieure 21a de la couche mince d'encapsulation 21 non revêtue par le relief 23, ainsi que sur la face supérieure 23a du relief 23. Le matériau de la couche mince de scellement 24 ne se dépose sensiblement pas sur les faces latérales 23b du relief 23 (à la différence d'un dépôt conforme effectué par dépôt chimique en phase vapeur), conduisant ainsi à la rupture locale de continuité de la couche mince de scellement 24. Il en résulte que la couche mince de scellement 24 est formée d'au moins une portion de couche 24.1 qui repose sur la couche mince d'encapsulation 21, et d'au moins un plot 24.2 qui repose sur le relief 23, ici un plot longitudinal sous forme d'une bande. Chaque portion de couche 24.1 est distincte et donc sans continuité de matière avec les plots longitudinaux 24.2 adjacents. En d'autres termes, il y a une séparation physique entre chaque portion de couche 24.1 et le ou les plots 24.2 adjacents (et inversement).

Dans le cas où le relief 23 forme un réseau continu en deux dimensions autour des détecteurs thermiques 10, les plots longitudinaux 24.2 sont joints les uns aux autres et forment également un réseau continu superposé à celui du relief 23. Il y a alors une rupture de continuité, c'est-à-dire une séparation physique, entre les plots longitudinaux 24.2 d'une part, et la ou les portions de couche 24.1 adjacentes d'autre part. De plus, les portions de couche 24.1 adjacentes sont distinctes les unes des autres dans le plan XY.

On comprend qu'une rupture de continuité d'une couche se distingue d'une simple rupture de planéité de la couche du fait du relief 23. On se distingue ici des documents de l'art antérieur qui décrivent le dépôt par exemple conforme d'une couche sur une surface plane revêtue localement d'un relief. Cette couche déposée peut alors s'étendre continûment sur la surface plane ainsi que sur les faces du relief. Dans ce cas, le relief entraîne une rupture de planéité de la couche déposée dans un plan XY, et non pas une rupture de continuité de la couche. Autrement dit, la partie de la couche située sur le relief n'est pas distincte (séparée physiquement) de la partie de la couche située sur la surface plane.

Par ailleurs, la rupture locale de continuité peut être renforcée par un phénomène d'ombrage associé aux plots 24.2 reposant sur le relief 23. En effet, du fait de la quasi-unidirectionnalité de l'émission de la source PVD du matériau à déposer, en particulier lors d'un dépôt par évaporation, les plots 24.2 présentent une section en coupe transversale évasée suivant la direction +Z, c'est-à-dire que la largeur dans le plan XY augmente à mesure qu'on s'éloigne du relief 23 suivant la direction +Z. Cet évasement des plots 24.2 se traduit par un rétrécissement des portions de couche 24.1 suivant la direction +Z. Ce phénomène d'ombrage renforce la rupture locale de continuité de la couche mince d'encapsulation 21.

Il en résulte que, du fait de la présence du relief 23 dont l'épaisseur moyenne eᵣ est adaptée à celle e_{cs} de la couche mince de scellement 24, une rupture locale de continuité de la couche mince de scellement 24 se forme au niveau du relief 23. Ainsi, la couche mince de scellement 24 présente une discontinuité de matière dans le plan XY, ce qui forme une zone de relaxation des contraintes mécaniques issues de la différence des coefficients de dilatation thermique entre les matériaux des couches minces d'encapsulation et de scellement 21, 24. La tenue mécanique de la structure d'encapsulation 20 est alors améliorée.

Il est particulièrement avantageux que le relief 23 forme un réseau bidimensionnel délimitant continûment chacun des détecteurs thermiques 10. Ainsi, la couche mince de scellement 24 déposée est alors formée d'une pluralité de portions de couche 24.1, distinctes les unes des autres et distinctes des plots 24.2 adjacents, disposées chacune en regard d'un détecteur thermique 10. La zone de relaxation des contraintes mécaniques entoure alors chaque portion 24.1 de couche mince de scellement 24, ce qui améliore davantage la tenue mécanique de la structure d'encapsulation 20.

En référence à la fig.2J, on réalise ensuite, de préférence, une couche mince antireflet 25, déposée par dépôt PVD de manière à recouvrir la couche mince de scellement 24. Du fait de la rupture locale de continuité de la couche mince de scellement 24 et de la technique de dépôt utilisée, i.e. PVD, la couche mince antireflet 25 présente également une rupture locale de continuité. Elle est ici formée de portions de couche 25.1 distinctes les unes des autres recouvrant les portions 24.1 de la couche mince de scellement 24, et de plots longitudinaux 25.2 distinctes recouvrant les plots longitudinaux 24.2 sous-jacentes de la couche mince de scellement 24. La couche mince antireflet 25 peut être réalisée en ZnS et présenter une épaisseur moyenne comprise entre quelques centaines de nanomètres et quelques microns, par exemple égale à 1,2µm environ dans le cadre de la détection du rayonnement LWIR.

Ainsi, le procédé de fabrication permet d'obtenir un dispositif de détection 1 dont la structure d'encapsulation 20 présente une tenue mécanique améliorée. Il permet avantageusement de réaliser la couche mince de scellement 24 et la couche mince antireflet 25 sous la forme d'une pluralité de portions 24.1, 25.1 de couches distinctes les unes des autres, i.e. sans continuité de matière entre elles dans le plan XY. Les contraintes mécaniques issues de la différence entre les coefficients CTE des différents matériaux de la structure d'encapsulation 20 peuvent alors relaxer de manière efficace. La structure d'encapsulation 20 présente alors une tenue mécanique améliorée lors de son exposition thermique à des températures élevées, comme par exemple l'activation à 300°C environ d'un matériau getter situé dans la cavité 3, ce matériau getter étant destiné à réagir avec du gaz résiduel éventuellement présent dans la cavité 3, pour maintenir celle-ci à un niveau de vide suffisant. Il peut également s'agir de l'étape de dépôt de la couche mince de scellement 24 et/ou de la couche mince antireflet 25, voire la brasure pour sceller des puces de détection unitaires à des boîtiers, etc...

Ce procédé de fabrication permet d'éviter d'avoir à mettre en œuvre, pour obtenir la rupture locale de continuité, une étape spécifique de gravure localisée de la couche mince de scellement 24, et le cas échéant, de la couche mince antireflet 25, lesquelles auraient été déposées sur la couche mince d'encapsulation 21 ne comportant pas de relief 23 à l'épaisseur adapté pour obtenir un tel effet, par exemple dans la configuration de la fig.1. Il permet en outre d'éviter les inconvénients qui pourraient résulter d'une telle gravure localisée.

En effet, il serait possible de réaliser une gravure humide localisée des couches minces de scellement et d'antireflet, celles-ci s'étendant de manière plane sur la couche mince d'encapsulation 21. Cependant, le caractère isotrope d'une gravure humide peut conduire à une gravure latérale de l'ordre de deux fois l'épaisseur des couches minces à graver. Ainsi, pour une épaisseur moyenne totale des couches minces de scellement et d'antireflet de l'ordre de 3000nm environ, on obtiendrait une tranchée présentant une dimension transversale dans le plan XY de l'ordre de 6µm, ce qui serait rédhibitoire pour les performances du dispositif de détection 1, notamment dans le cas où le pas pixel de la matrice de détecteurs thermiques 10 est de l'ordre de 12µm ou moins.

Par ailleurs, il serait également possible de réaliser une gravure sèche localisée (par exemple par plasma) des couches minces de scellement et d'antireflet. Cependant, le matériau utilisé pour réaliser la couche mince de scellement 24 peut présenter une faible sélectivité de gravure vis-à-vis du matériau de la couche mince d'encapsulation 21, comme c'est le cas du germanium vis-à-vis du silicium amorphe. La gravure sèche serait alors contrôlée au temps, ce qui peut alors conduire, soit à une gravure seulement partielle de la couche mince de scellement 24 et donc à une absence de rupture locale de continuité ; soit à une gravure totale de la couche mince de scellement 24, mais également à une gravure (partielle) de la couche mince d'encapsulation 21, ce qui entraînerait alors une fragilisation accrue de la tenue mécanique de la structure d'encapsulation 20. Pour pallier à l'absence de sélectivité de gravure entre les matériaux des couches minces d'encapsulation et de scellement, une couche mince d'arrêt de gravure pourrait être intercalée entre les deux couches minces, mais au prix d'une dégradation des performances du dispositif de détection 1 dans la mesure où le matériau de la couche mince d'arrêt de gravure peut absorber une proportion non nulle du rayonnement électromagnétique à détecter.

Il en résulte que le procédé de fabrication selon l'invention permet d'améliorer la tenue mécanique de la structure d'encapsulation 20, en générant une rupture locale de continuité de la couche mince de scellement 24, et le cas échéant, de la couche mince antireflet 25, par la présence du relief 23 à l'épaisseur adaptée à cet effet. Il n'est pas nécessaire d'avoir recours à une étape spécifique de gravure localisée des couches minces de scellement et d'antireflet, ce qui permet notamment de préserver les performances du dispositif de détection 1.

Des modes de réalisation particuliers viennent d'être décrits. Différentes variantes et modifications apparaîtront à l'homme du métier.

## Revendications

1. Procédé de fabrication d'un dispositif de détection (1) d'un rayonnement électromagnétique comportant au moins un détecteur thermique (10) reposant sur un substrat (2) et une structure d'encapsulation (20) définissant avec le substrat (2) une cavité (3) dans laquelle est situé le détecteur thermique (10), comportant les étapes suivantes :
∘ réalisation du détecteur thermique (10) à partir d'au moins une première couche sacrificielle (31) déposée sur le substrat (2) ;
∘ réalisation d'une couche mince d'encapsulation (21) de la structure d'encapsulation (20) s'étendant au-dessus du détecteur thermique (10) à partir d'au moins une deuxième couche sacrificielle (32) reposant sur la première couche sacrificielle (31), la couche mince d'encapsulation (21) étant réalisée en un matériau d'encapsulation ;
∘ réalisation par dépôt physique en phase vapeur (PVD) d'une couche mince dite de scellement (24) recouvrant la couche mince d'encapsulation (21), la couche mince de scellement (24) étant réalisée en un matériau de scellement présentant un coefficient de dilatation thermique différent de celui du matériau d'encapsulation ;
**caractérisé en ce qu'**il comporte en outre l'étape suivante :
∘ préalablement à l'étape de réalisation de la couche mince de scellement (24), réalisation d'au moins un relief (23) sur la couche mince d'encapsulation (21), présentant une épaisseur moyenne adaptée de sorte que, lors du dépôt de la couche mince de scellement (24), celle-ci est formée d'au moins une portion de couche (24.1) reposant sur la couche mince d'encapsulation (21), et d'au moins un plot (24.2) distinct de la portion de couche (24.1) et reposant sur le relief (23), formant ainsi une rupture locale de continuité de la couche mince de scellement (24) au niveau du relief (23).

2. Procédé de fabrication selon la revendication 1, dans lequel le relief (23) forme un réseau à deux dimensions de portions longitudinales entourant au moins partiellement, en projection orthogonale par rapport au substrat (2), le détecteur thermique (10).

3. Procédé de fabrication selon la revendication 2, dans lequel le réseau de portions longitudinales du relief (23) entoure, en projection orthogonale par rapport au substrat (2), le détecteur thermique (10), de manière continue, de sorte que le plot (24.2) s'étend de manière continue sur le réseau de portions longitudinales du relief (23) et est distinct de la portion de couche (24.1) entourée par le réseau de portions longitudinales du relief (23).

4. Procédé de fabrication selon l'une quelconque des revendications 1 à 3, dans lequel le détecteur thermique (10) comporte une membrane absorbante (11) suspendue au-dessus du substrat (2) et contenant un transducteur thermométrique (12), le relief (23) étant disposé à distance, en projection orthogonale par rapport au substrat (2), de la membrane absorbante (11).

5. Procédé de fabrication selon l'une quelconque des revendications 1 à 4, dans lequel la couche mince de scellement (24) présente une épaisseur moyenne e_{cs}, le relief (23) présentant une épaisseur moyenne eᵣ supérieure ou égale à un cinquième de l'épaisseur moyenne e_{cs}.

6. Procédé de fabrication selon l'une quelconque des revendications 1 à 5, dans lequel l'étape de réalisation du relief (23) comporte un dépôt d'une première couche en un matériau distinct de celui de la couche mince d'encapsulation (21), puis une structuration locale par gravure sélective de la première couche vis-à-vis de la couche mince d'encapsulation (21) de manière à former le relief (23).

7. Procédé de fabrication selon l'une quelconque des revendications 1 à 6, dans lequel le dispositif de détection (1) comporte une matrice de détecteurs thermiques (10) disposée dans ladite cavité (3), le relief (23) formant un réseau à deux dimensions de portions longitudinales entourant au moins partiellement, en projection orthogonale par rapport au substrat (2), chacun des détecteurs thermiques (10).

8. Procédé de fabrication selon l'une quelconque des revendications 1 à 7, dans lequel la couche mince d'encapsulation (21) est réalisée à base de silicium et la couche mince de scellement (24) est réalisée à base de germanium.

9. Procédé de fabrication selon l'une quelconque des revendications 1 à 8, dans lequel la couche mince de scellement (24) est déposée par évaporation.

10. Procédé de fabrication selon l'une quelconque des revendications 1 à 9, comportant une étape de réalisation d'une couche mince antireflet (25) par dépôt physique en phase vapeur sur la couche mince de scellement (24), la couche mince antireflet (25) présentant alors une rupture locale de continuité.

11. Procédé de fabrication selon l'une quelconque des revendications 1 à 10, comportant :
∘ entre l'étape de réalisation du relief (23) et l'étape de réalisation de la couche mince de scellement (24), une étape de formation d'au moins un orifice traversant dit évent de libération (22) au travers de la couche mince d'encapsulation (21),
• la couche mince de scellement (24) étant ensuite réalisée de manière à obturer l'évent de libération (22),
∘ une étape de suppression des couches sacrificielles (31, 32) au travers de l'évent de libération (22).

## Patentansprüche

1. Verfahren zur Herstellung einer Vorrichtung zur Erfassung (1) einer elektromagnetischen Strahlung, die mindestens einen auf einem Substrat (2) aufliegenden thermischen Detektor (10) und eine Einkapselungsstruktur (20) aufweist, die mit dem Substrat (2) einen Hohlraum (3) definiert, in dem sich der thermische Detektor (10) befindet, das die folgenden Schritte aufweist:
∘ Herstellung des thermischen Detektors (10) ausgehend von mindestens einer auf das Substrat (2) aufgebrachten ersten Opferschicht (31) ;
∘ Herstellung einer dünnen Einkapselungsschicht (21) der Einkapselungsstruktur (20), die sich oberhalb des thermischen Detektors (10) erstreckt, ausgehend von mindestens einer auf der ersten Opferschicht (31) aufliegenden zweiten Opferschicht (32), wobei die dünne Einkapselungsschicht (21) aus einem Einkapselungsmaterial hergestellt wird;
∘ Herstellung einer dünnen so genannten Versiegelungsschicht (24) durch physikalische Dampfabscheidung (PVD), die die dünne Einkapselungsschicht (21) bedeckt, wobei die dünne Versiegelungsschicht (24) aus einem Versiegelungsmaterial hergestellt wird, das einen anderen Wärmeausdehnungskoeffizienten als derjenige des Einkapselungsmaterials aufweist;
**dadurch gekennzeichnet, dass** es außerdem den folgenden Schritt aufweist:
∘ vor dem Schritt der Herstellung der dünnen Versiegelungsschicht (24), Herstellung mindestens eines Reliefs (23) auf der dünnen Einkapselungsschicht (21), das eine derart angepasste mittlere Dicke aufweist, dass beim Aufbringen der dünnen Versiegelungsschicht (24) diese von mindestens einem auf der dünnen Einkapselungsschicht (21) aufliegenden Schichtabschnitt (24.1) und mindestens einem Block (24.2) anders als der Schichtabschnitt (24.1) und auf dem Relief (23) aufliegend geformt wird, wodurch eine lokale Kontinuitätsunterbrechung der dünnen Versiegelungsschicht (24) im Bereich des Reliefs (23) geformt wird.

2. Herstellungsverfahren nach Anspruch 1, wobei das Relief (23) ein zweidimensionales Gitter von Längsabschnitten bildet, das den thermischen Detektor (10) zumindest teilweise in orthogonaler Projektion bezüglich des Substrats (2) umgibt.

3. Herstellungsverfahren nach Anspruch 2, wobei das Gitter von Längsabschnitten des Reliefs (23) den thermischen Detektor (10) in orthogonaler Projektion bezüglich des Substrats (2) kontinuierlich umgibt, so dass der Block (24.2) sich kontinuierlich auf dem Gitter von Längsabschnitten des Reliefs (23) erstreckt und sich von dem Schichtabschnitt (24.1) unterscheidet, der vom Gitter von Längsabschnitten des Reliefs (23) umgeben ist.

4. 4 Herstellungsverfahren nach einem der Ansprüche 1 bis 3, wobei der thermische Detektor (10) eine absorbierende Membran (11) aufweist, die oberhalb des Substrats (2) aufgehängt ist und einen thermometrischen Wandler (12) enthält, wobei das Relief (23) in orthogonaler Projektion bezüglich des Substrats (2) in Abstand zur absorbierenden Membran (11). angeordnet ist.

5. Herstellungsverfahren nach einem der Ansprüche 1 bis 4, wobei die dünne Versiegelungsschicht (24) eine mittlere Dicke e_{cs} aufweist, wobei das Relief (23) eine mittlere Dicke eᵣ größer als oder gleich einem Fünftel der mittleren Dicke e_{cs} aufweist.

6. Herstellungsverfahren nach einem der Ansprüche 1 bis 5, wobei der Schritt der Herstellung des Reliefs (23) ein Aufbringen einer ersten Schicht aus einem Material anders als dasjenige der dünnen Einkapselungsschicht (21), dann eine lokale Strukturierung durch selektives Ätzen der ersten Schicht gegenüber der dünnen Einkapselungsschicht (21) aufweist, um das Relief (23) zu formen.

7. Herstellungsverfahren nach einem der Ansprüche 1 bis 6, wobei die Erfassungsvorrichtung (1) eine Matrix von thermischen Detektoren (10) aufweist, die im Hohlraum (3) angeordnet ist, wobei das Relief (23) ein zweidimensionales Gitter von Längsabschnitten formt, das zumindest teilweise in orthogonaler Projektion bezüglich des Substrats (2) jeden der thermischen Detektoren (10) umgibt.

8. Herstellungsverfahren nach einem der Ansprüche 1 bis 7, wobei die dünne Einkapselungsschicht (21) auf der Basis von Silicium und die dünne Versiegelungsschicht (24) auf der Basis von Germanium hergestellt wird.

9. Herstellungsverfahren nach einem der Ansprüche 1 bis 8, wobei die dünne Versiegelungsschicht (24) durch Bedampfung aufgebracht wird.

10. Herstellungsverfahren nach einem der Ansprüche 1 bis 9, das einen Schritt der Herstellung einer dünnen Antireflexschicht (25) durch physikalische Dampfabscheidung auf die dünne Versiegelungsschicht (24) aufweist, wobei die dünne Antireflexschicht (25) dann eine lokale Kontinuitätsunterbrechung aufweist.

11. Herstellungsverfahren nach einem der Ansprüche 1 bis 10, das aufweist:
∘ zwischen dem Schritt der Herstellung des Reliefs (23) und dem Schritt der Herstellung der dünnen Versiegelungsschicht (24) einen Schritt des Formens mindestens einer Auslassöffnung genannten Durchgangsöffnung (22) durch die dünne Einkapselungsschicht (21) hindurch,
• wobei die dünne Versiegelungsschicht (24) anschließend so hergestellt wird, dass sie die Auslassöffnung (22) verschließt,
∘ einen Schritt des Entfernens der Opferschichten (31, 32) durch die Auslassöffnung (22) hindurch.

## Claims

1. Process for fabricating a device (1) for detecting electromagnetic radiation comprising at least one thermal detector (10) resting on a substrate (2) and one encapsulation structure (20) defining, with the substrate (2), a cavity (3) in which the thermal detector (10) is located, comprising the following steps:
∘ producing the thermal detector (10) from at least one first sacrificial layer (31) deposited on the substrate (2);
∘ producing a thin encapsulation layer (21) of the encapsulation structure (20) extending above the thermal detector (10) from at least one second sacrificial layer (32) resting on the first sacrificial layer (31), the thin encapsulation layer (21) being made of an encapsulation material;
∘ producing, by physical vapour deposition (PVD), a thin "sealing" layer (24) covering the thin encapsulation layer (21), the thin sealing layer (24) being made of a sealing material having a coefficient of thermal expansion different from that of the encapsulation material;
**characterized in that** it furthermore comprises the following step:
∘ prior to the step of producing the thin sealing layer (24), producing at least one relief (23) on the thin encapsulation layer (21) having a suitable average thickness so that, during the deposition of the thin sealing layer (24), the latter is formed from at least one layer segment (24.1) resting on the thin encapsulation layer (21) and from at least one pad (24.2) that is separate from the layer segment (24.1) and that rests on the relief (23), thus forming a local breakage in the continuity of the thin sealing layer (24) at the relief (23).

2. Fabricating process according to Claim 1, wherein the relief (23) forms a two-dimensional array of longitudinal segments at least partially encircling the thermal detector (10) in orthogonal projection with respect to the substrate (2).

3. Fabricating process according to Claim 2, wherein, in orthogonal projection with respect to the substrate (2), the array of longitudinal segments of the relief (23) encircles the thermal detector (10) continuously, so that the pad (24.2) extends continuously over the array of longitudinal segments of the relief (23) and is separate from the layer segment (24.1) encircled by the array of longitudinal segments of the relief (23).

4. Fabricating process according to any one of Claims 1 to 3, wherein the thermal detector (10) comprises an absorbent membrane (11) suspended above the substrate (2) and containing a thermometric transducer (12), the relief (23) being placed at a distance, in orthogonal projection with respect to the substrate (2), from the absorbent membrane (11).

5. Fabricating process according to any one of Claims 1 to 4, wherein the thin sealing layer (24) has an average thickness e_{cs}, the relief (23) having an average thickness eᵣ larger than or equal to one fifth of the average thickness e_{cs}.

6. Fabricating process according to any one of Claims 1 to 5, wherein the step of producing the relief (23) comprises depositing a first layer made of a material different from that of the thin encapsulation layer (21), then locally structuring the first layer by etching it selectively vis-à-vis the thin encapsulation layer (21) so as to form the relief (23).

7. Fabricating process according to any one of Claims 1 to 6, wherein the detecting device (1) comprises a matrix array of thermal detectors (10) placed in said cavity (3), the relief (23) forming a two-dimensional array of longitudinal segments at least partially encircling each of the thermal detectors (10) in orthogonal projection with respect to the substrate (2).

8. Fabricating process according to any one of Claims 1 to 7, wherein the thin encapsulation layer (21) is silicon-based and the thin sealing layer (24) is germanium-based.

9. Fabricating process according to any one of Claims 1 to 8, wherein the thin sealing layer (24) is deposited by evaporation.

10. Fabricating process according to any one of Claims 1 to 9, comprising a step of producing a thin antireflection layer (25) by physical vapour deposition on the thin sealing layer (24), the thin antireflection layer (25) then having a local breakage in continuity.

11. Fabricating process according to any one of Claims 1 to 10, comprising:
∘ between the step of producing the relief (23) and the step of producing the thin sealing layer (24), a step of forming at least one through-orifice called the release vent (22) through the thin encapsulation layer (21),
• the thin sealing layer (24) then being produced so as to block the release vent (22),
∘ a step of removing the sacrificial layers (31, 32) through the release vent (22).
